# EUROPEAN PATENT SPECIFICATION

(11) **EP 4 528 950 B1**
(45) Date of publication and mention of the grant of the patent: **09.09.2026**
(21) Application number: 23918183.7
(22) Date of filing: 15.09.2023
(51) Int. Cl.: G06F 1/16, G06F 1/18, H05K 7/14, H05K 7/02, H02G 3/32

(54) **THREADING STRUCTURE AND SERVER**
THREADING-STRUKTUR UND SERVER
STRUCTURE DE FILETAGE ET SERVEUR

(30) Priority: 28.01.2023 CN 202310042971
(43) Date of publication of application: 26.03.2025
(73) Proprietor: Suzhou Metabrain Intelligent Technology Co., Ltd., Suzhou, Jiangsu 215000 (CN)
(72) Inventor: YIN, Xiuzhong, Suzhou, Jiangsu 215000 (CN); ZHU, Jingxian, Suzhou, Jiangsu 215000 (CN); CAO, Zhencai, Suzhou, Jiangsu 215000 (CN); LI, Zhanyang, Suzhou, Jiangsu 215000 (CN)
(74) Representative: Viering, Jentschura & Partner mbB Patent- und Rechtsanwälte
(86) International application number: PCT/CN2023/118968
(87) International publication number: WO 2024/156182

(56) References cited:
- CN-A- 109 340 314
- CN-A- 111 356 324
- CN-A- 113 359 958
- CN-A- 115 776 080
- CN-U- 209 560 430
- CN-U- 218 386 092
- JP-U- 3 220 197
- US-A1- 2003 213 876
- US-A1- 2007 217 139
- US-A1- 2012 024 591
- US-A1- 2020 167 739
- US-A1- 2021 120 697

## Description

### CROSS-REFERENCE TO RELATED APPLICATION

The present application claims the priority of the Chinese patent application filed on January 28th, 2023 before the Chinese Patent Office with the application number of 20231004297.1 and the title of "THREADING STRUCTURE AND SERVER".

### FIELD

The present application relates to the technical field of cable threading, and particularly relates to a threading device and a server.

### BACKGROUND

With the continuous expansion of the functions of servers, the structures of the servers are increasingly more complicated. When a server has multiple layers of nodes, there is a problem in the wiring of the cables that connect the computation node layer and the high-speed serial computer expansion-bus standard (Peripheral Component Interconnect Express, PCIE) module node layer. Currently, the wiring of the cables between the PCIE module node layer and the computation node layer is generally in two modes. The first type is wiring from the two sides of the mainboard to the rear end of the crate, and connecting to the PCIE module node layer by using an intelligent Contiguous Memory Allocation (CMA) technique. In such a mode, the cables are too long, which results in an unsatisfactory signal integrity (SI). The second type is that wiring holes are provided at the front and the rear of the mainboard, and the cables and the PCIE module node layer are directly interconnected via the wiring holes. Such a mode can ensure that the SI signal is satisfactory. However, in the threading, it is required that two persons lift the computation node layer, while another person performs the threading, which causes that the server assembling has high labor cost and time cost, which reduces the efficiency of the assembling of the server. US 2021/120697 A1 discloses systems and methods for holding cables in a computing system using one or more rotatable cable holders. US 2007/217139 A1 discloses a compartmented computer case which is easily assembly and facilitates heat removal during the computer operation. US 2003/213876 A1 discloses a fixing tool which performs fixing by utilizing a mounting hole formed in the board.

### SUMMARY

The present application provides a threading device and a server, to solve the problem in the server assembling in the prior art of high labor cost and time cost.

The invention is set out in the appended set of claims.

In the threading device according to the present application, by providing the tray, and providing the wiring hole and the cable temporarily-storing member on the tray, the cable of the PCIE module layer may be caused to pass through the wiring hole, subsequently be fixed by the cable temporarily-storing member, and subsequently be connected to the computation layer. In the connecting process, the threading device and the computation layer are sequentially installed, which does not require simultaneous operation by multiple persons, thereby simplifying the process of the assembling of the server, increasing the efficiency of the assembling of the server, and reducing the labor cost and the time cost.

### BRIEF DESCRIPTION OF THE DRAWINGS

In order to more clearly illustrate the technical solutions of the present application or the prior art, the figures that are required to describe the embodiments or the prior art will be briefly described below. Apparently, the figures that are described below are embodiments of the present application, and a person skilled in the art can obtain other figures according to these figures without paying creative work.
FIG. 1 is a schematic structural diagram of a threading device according to the present application;
FIG. 2 is a schematic structural diagram of the cable temporarily-storing member shown in FIG. 1 in the first position;
FIG. 3 is a schematic structural diagram of the cable temporarily-storing member shown in FIG. 1;
FIG. 4 is a schematic structural diagram of the cable temporarily-storing member shown in FIG. 1 in the second position;
FIG. 5 is a schematic structural diagram when the first cable clamps shown in FIG. 1 are opened;
FIG. 6 is a schematic structural diagram when the first cable clamps shown in FIG. 1 are closed;
FIG. 7 is a partially enlarged view of the position A in FIG. 1;
FIG. 8 is a side view of a server crate; and
FIG. 9 is an exploded view of a computation layer, a threading device and a PCIE module layer.

Reference numbers:
100: tray; 101: first wiring hole; 102: second wiring hole; 110: third bottom plate; 120: border frame; 200: cable temporarily-storing member; 201: first bottom plate; 202: side plates; 203: first positioning member; 204: second clipping hooks; 211: connecting plate; 212: first boss; 213: first snap-fitting member; 214: second positioning member; 300: first cable clamps; 301: second bottom plate; 302: second boss; 303: second clipping slot; 311: first snap-fitting part; 312: second snap-fitting part; 313: third snap-fitting part; 314: fourth snap-fitting part; 400: second cable clamps; 500: sealing foam; 600: computation layer; 601: mainboard; 602: power board; 700: PCIE module layer; 1201: connecting slots; 1202: elastic pieces; 2121: first clipping slot; 2131: first clipping hook; 3141: first main body; and 3142: second main body.

### DETAILED DESCRIPTION

In order to make the objects, the technical solutions and the advantages of the present application clearer, the technical solutions according to the present application will be clearly and completely described below with reference to the drawings according to the present application. Apparently, the described embodiments are merely certain embodiments of the present application, rather than all of the embodiments. All of the other embodiments that a person skilled in the art obtains on the basis of the embodiments of the present application without paying creative work fall within the protection scope of the present application.

The features defined by the terms "first" and "second" in the description and the claims of the present application may explicitly or implicitly comprise one or more of the features. In the description of the present application, unless stated otherwise, the meaning of "plurality of" is "two or more".

In the description of the present application, it should be understood that the terms that indicate orientation or position relations, such as "central", "longitudinal", "transverse", "length", "width", "thickness", "upper", "lower", "front", "rear", "left", "right", "vertical", "horizontal", "top", "bottom", "inner" and "outer", are based on the orientation or position relations shown in the drawings, and are merely for conveniently describing the present application and simplifying the description, rather than indicating or implying that the device or element must have the specific orientation and be constructed and operated according to the specific orientation. Therefore, they should not be construed as a limitation on the present application.

In the description of the present application, it should also be noted that, unless explicitly defined or limited otherwise, the terms "provide", "mount", "connect" and "link" should be interpreted broadly. For example, it may be fixed connection, detachable connection, or integral connection; it may be mechanical connection or electrical connection; and it may be direct connection or indirect connection by an intermediate medium, and may be the internal communication between two elements. For a person skilled in the art, the particular meanings of the above terms in the present application may be comprehended according to particular situations.

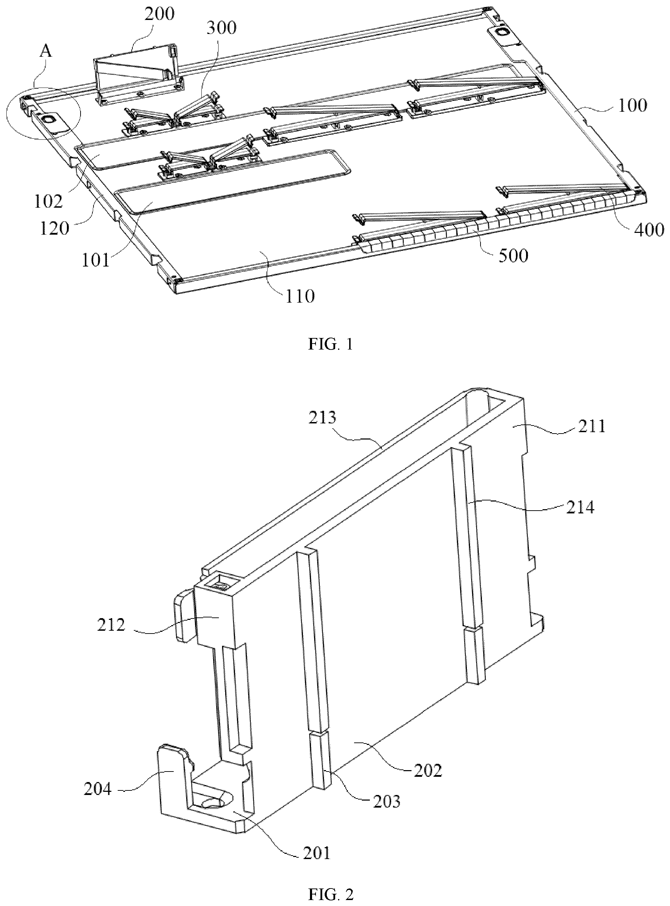

The threading device and the server according to the present application will be described below with reference to FIGS. 1-9.

As shown in FIG. 1, in an embodiment of the present application, the threading device comprises a tray 100 and a cable temporarily-storing member 200. The tray 100 is for being installed inside a server crate, and located over a PCIE module layer 700, the tray 100 is provided with a wiring hole, and the wiring hole is for the penetration by a cable. The cable temporarily-storing member 200 is provided at the tray 100, and the cable temporarily-storing member 200 is for fixing the cable that has passed through the wiring hole.

Particularly, in the prior art, both of a computation layer 600 and the PCIE module layer 700 are provided inside the server crate, and the computation layer 600 is located over the PCIE module layer 700. The computation layer 600 is provided with the components such as a mainboard 601 and a power board 602. The PCIE module layer 700 is provided with a PCIE form card and a Riser card, wherein the Riser card is an expansion card. In the assembling of the server, it is required to connect the PCIE form card and the power board 602 by using a cable, and connect the Riser card and the mainboard 601 by using a cable.

In the present embodiment, firstly the PCIE module layer 700 is installed into the server crate, the cables that are connected to the PCIE form card and the Riser card are caused to pass through the wiring hole, and subsequently the threading device is installed into the server crate. The cables that have passed through the wiring hole pass through the cable temporarily-storing member 200, whereby the cable temporarily-storing member 200 may clamp the cables, subsequently the computation layer 600 is installed into the server crate, and finally the cables are connected to the power board 602 and the mainboard 601 of the computation layer 600.

In the threading device according to the embodiments of the present application, by providing the tray, and providing the wiring hole and the cable temporarily-storing member on the tray, the cable of the PCIE module layer may be caused to pass through the wiring hole, subsequently be fixed by the cable temporarily-storing member, and subsequently be connected to the computation layer. In the connecting process, the threading device and the computation layer are sequentially installed, which does not require simultaneous operation by multiple persons, thereby simplifying the process of the assembling of the server, increasing the efficiency of the assembling of the server, and reducing the labor cost and the time cost.

As shown in FIG. 2, in an embodiment of the present application, the cable temporarily-storing member 200 comprises a base and a clamping mechanism. The base is provided at the tray 100, the clamping mechanism is connected to the base, the clamping mechanism is openable and closable, and the clamping mechanism is for fixing the cable that has passed through the wiring hole.

Particularly, the cable connected to the PCIE module layer 700, after passing through the wiring hole, penetrates the clamping mechanism, wherein the clamping mechanism is for fixing the cable, and, subsequently, after the computation layer 600 has been installed into the server crate, the cable is connected to the computation layer.

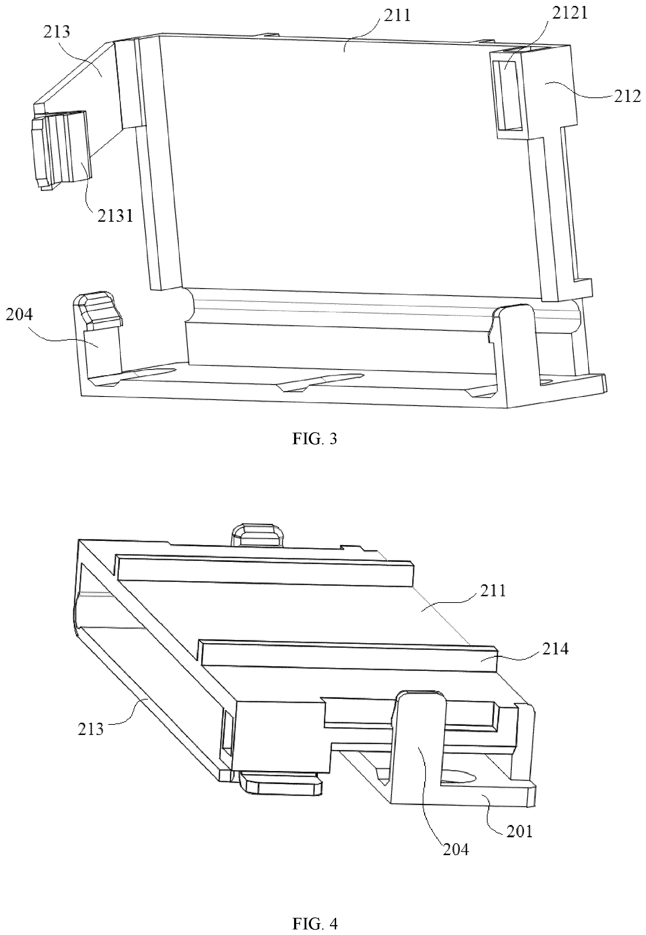

Optionally, as shown in FIG. 3, in an embodiment of the present application, the clamping mechanism comprises a connecting plate 211, a first boss 212 and a first snap-fitting member 213. The connecting plate 211 is connected to the base, the connecting plate 211 has a first surface, a first end of the first surface is provided with the first boss 212, and the first boss 212 is provided with a first clipping slot 2121. A first end of the first snap-fitting member 213 is rotatably connected to a second end of the first surface, a second end of the first snap-fitting member 213 is provided with a first clipping hook 2131, the first clipping hook 2131 is capable of being snap-fitted to the first clipping slot 1212, and when the first clipping hook 2131 is snap-fitted to the first clipping slot 2121, the first snap-fitting member 213 and the connecting plate 211 form a cable accommodating space therebetween.

Particularly, in the present embodiment, the first snap-fitting member 213 is capable of being snap-fitted to the first clipping slot 2121, to cause the clamping mechanism to be openable and closable. When the first snap-fitting member 213 is snap-fitted to the first clipping slot 2121, the space between the first snap-fitting member 213 and the connecting plate 211 forms the cable accommodating space. When the cable is being fixed, firstly the first snap-fitting member 213 and the first clipping slot 2121 are disengaged, the cable is straightened and subsequently adhered to the connecting plate 211, and subsequently the first snap-fitting member 213 is snap-fitted to the first clipping slot 2121, so as to fix the cable.

In the threading device according to the embodiments of the present application, by providing the clamping mechanism, the cable that has passed through the wiring hole may be fixed, and when the cable penetrates the clamping mechanism, the cable may be in the vertical state by using the tension of the cable and the clamping force of the clamping mechanism, which facilitates to, after the computation layer has been installed, connect the cable to the computation layer. By using the threading device according to the embodiments of the present application, one person may assemble the server crate, which increases the efficiency of the assembling of the server.

As shown in FIGS. 2 and 4, in an embodiment of the present application, the connecting plate 211 is rotatably connected to the base, and the connecting plate 211 has a first position and a second position that are switchable. When the connecting plate 211 is in the first position, the connecting plate 211 and the tray 100 are perpendicular, and the cable is located inside the cable accommodating space. When the connecting plate 211 is in the second position, the connecting plate 211 and the tray 100 are parallel, and the cable is located outside the cable accommodating space.

Particularly, after the cable has passed through the wiring hole, it is required to fix the cable. The connecting plate 211 is in the first position; in other words, the connecting plate 211 is in a vertical position, and is perpendicular to the tray 100, whereby the cable that has passed through the cable accommodating space points upwardly. After the cable has been straightened, the cable is in the vertical state by using the tension of itself and the clamping force of the clamping mechanism. After the computation layer 600 has been installed, the first snap-fitting member 213 and the first clipping slot 2121 are disengaged, to release the cable, and the cable is connected to the computation layer 600. Subsequently, the connecting plate 211 is flipped, to cause it to be parallel to the tray 100; in other words, the connecting plate 211 is in a horizontal position, which is the second position of the connecting plate 211.

In the threading device according to the embodiments of the present application, by configuring the connecting plate to have the two positions, when the connecting plate is in the first position, it has a higher height, which may fix the cable. When the connecting plate is in the second position, it has a lower height, which may increase the spacing between the threading device and the computation layer, to facilitate the heat dissipation of the computation layer.

Optionally, in an embodiment of the present application, the connecting plate 211 may be rotatably connected to the base by a rotation shaft. In another embodiment of the present application, the connecting plate 211 may also be flexibly connected to the base. Particularly, the material of the connection between the connecting plate 211 and the base may be a flexible material such as silica gel, so that the connecting plate 211 is capable of rotating relative to the base.

As shown in FIG. 2, in an embodiment of the present application, the base comprises a first bottom plate 201 and a side plate 202. The first bottom plate 201 is provided on the tray 100, the side plate 202 is perpendicular to the first bottom plate 201, and the side plate 202 is provided with a first positioning member 203. The connecting plate 211 further has a second surface opposite to the first surface, the second surface is provided with a second positioning member 214, and when the connecting plate 211 is in the first position, the second positioning member 214 abuts the first positioning member 203.

Particularly, the first positioning member 203 and the second positioning member 214 are for positioning the rotation angle of the connecting plate 211. When the connecting plate 211 has rotated to the first position from the second position, or, in other words, when the connecting plate 211 has flipped to the vertical state from the horizontal state, the second positioning member 214 exactly abuts the first positioning member 203, which may prevent the connecting plate 211 from excessively flipping, to ensure that the connecting plate 211 is perpendicular to the first bottom plate 201.

In the threading device according to the embodiments of the present application, by providing the first positioning member at the base, and providing the second positioning member at the connecting plate, when the connecting plate has flipped to the vertical state from the horizontal state, the second positioning member abuts the first positioning member, to serve for limiting, which prevents the connecting plate from excessively flipping, so as to ensure that the cable that has passed through the clamping mechanism is in the vertical state.

As shown in FIG. 4, in an embodiment of the present application, second clipping hooks 204 are provided at the two ends of the first bottom plate 201, and when the connecting plate 211 is in the second position, the second clipping hooks 204 are snap-fitted to the second surface of the connecting plate 211.

Particularly, slots are provided at the two ends of the second surface of the connecting plate 211, and when the connecting plate 211 is in the second position, the second clipping hooks 204 are snap-fitted to the slots, so as to cause the clamping mechanism and the base to be fixed to form an entirety.

As shown in FIG. 1, in an embodiment of the present application, the threading device further comprises a plurality of cable clamps, the cable clamps are provided at the tray 100, and the cable clamps are for fixing the cable.

Particularly, in an embodiment of the present application, the plurality of cable clamps include a plurality of first cable clamps 300 and a plurality of second cable clamps 400. The wiring hole is a plurality of wiring holes, and the plurality of wiring holes include a first wiring hole 101 and a second wiring hole 102.

Particularly, the plurality of first cable clamps 300 are arranged between the first wiring hole 101 and the cable temporarily-storing member 200, and the first cable clamps 300 and the cable temporarily-storing member 200 are for fixing the cable that has passed through the first wiring hole 101.

Particularly, the cable connected to the Riser card sequentially passes through the first wiring hole 101 and the plurality of first cable clamps 300, and subsequently penetrates the clamping mechanism of the cable temporarily-storing member 200, and the clamping mechanism fixes the cable. After the operator has straightened the cable, the cable is in the vertical state by using the tension of itself and the clamping force of the clamping mechanism. After the computation layer 600 has been installed, the first snap-fitting member 213 and the first clipping slot 2121 of the clamping mechanism are disengaged, to release the cable, the cable is connected to the computation layer 600, and subsequently the connecting plate 211 is flipped by 90°, to cause the connecting plate 211 to be parallel to the tray 100.

Optionally, in the present embodiment, between the first wiring hole 101 and the cable temporarily-storing member 200, in the direction of extension of the cable, a plurality of first cable clamps 300 may be provided to fix the direction of extension of the cable.

The second wiring hole 102 is located between the first wiring hole 101 and the cable temporarily-storing member 200, the plurality of second cable clamps 400 are located on one side of the second wiring hole 102, and the second cable clamps 400 are for fixing the cable that has passed through the second wiring hole 102.

Particularly, the cable connected to the PCIE form card passes through the second wiring hole 102, subsequently passes through the second cable clamps 400, and is connected to the power board 602 of the computation layer 600. In an embodiment, in the direction of wiring of the cable there may be a plurality of second cable clamps 400, to fix the direction of extension of the cable.

Further, in the above embodiments, both of the first wiring hole 101 and the second wiring hole 102 are rectangular holes, and have large sizes, so that a plurality of cables may pass through the first wiring hole 101 and the second wiring hole 102 at the same time. Moreover, the large sizes may facilitate the plurality of cables to be arranged side by side, which improves the aesthetic degree of the cables wiring. In the embodiment shown in FIG. 1, the length of the second wiring hole 102 is greater than the length of the first wiring hole 101. In an embodiment, the length of the second wiring hole 102 may also be equal to the length of the first wiring hole 101, or less than the length of the first wiring hole 101, as long as it is satisfied that the first wiring hole 101 and the second wiring hole are arranged in stagger, to facilitate the cable connected to the PCIE form card to be connected to the mainboard 601.

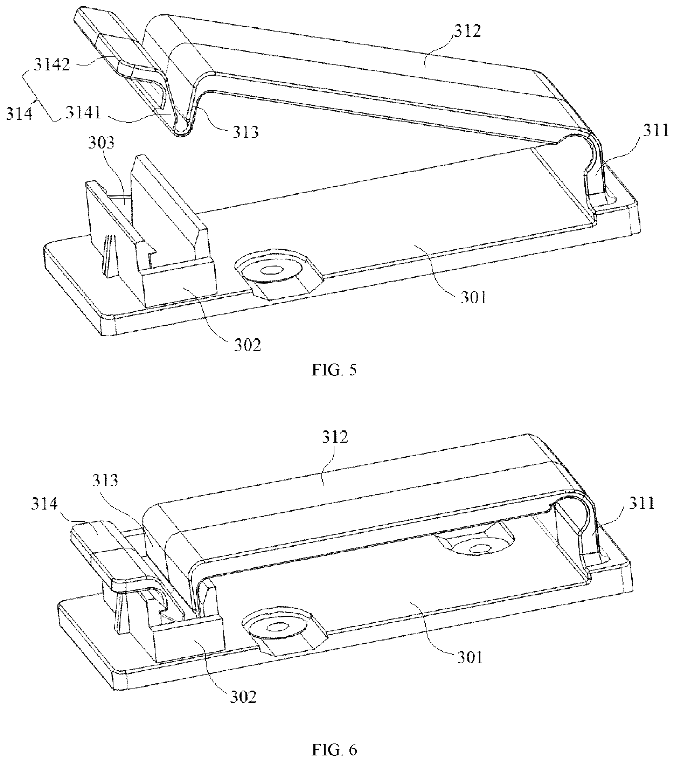

As shown in FIGS. 5 and 6, in an embodiment of the present application, the structures of the first cable clamp 300 and the second cable clamp 400 are the same. The particular structures of the first cable clamp 300 and the second cable clamp 400 will be described in detail below by taking the first cable clamp 300 as an example.

The first cable clamp 300 comprises a second bottom plate 301, a second boss 302 and a second snap-fitting member. The second bottom plate 301 is provided on the tray 100, the second boss 302 is provided at a first end of the second bottom plate 301, and the surface of the second boss 302 that is opposite to the second bottom plate 301 is provided with a second clipping slot 303. The second snap-fitting member comprises a first snap-fitting part 311, a second snap-fitting part 312 and a third clipping hook that are sequentially connected, the first snap-fitting part 311 is perpendicular to the second bottom plate 301, and is connected to a second end of the second bottom plate 301, the second snap-fitting part 312 is rotatably connected to the first snap-fitting part 311, and the third clipping hook is capable of being snap-fitted to the second clipping slot 303.

In an embodiment, the third clipping hook comprises a third snap-fitting part 313 and a fourth snap-fitting part 314. The third snap-fitting part 313 and the second snap-fitting part 312 are perpendicular and connected, the fourth snap-fitting part 314 comprises a first main body 3141 and a second main body 3142 that are connected, the included angle between the first main body 3141 and the second main body 3142 is an obtuse angle, the first main body 3141 is elastically connected to the third snap-fitting part 313, and the included angle between the first main body 3141 and the third snap-fitting part 313 is an acute angle. When the third clipping hook is snap-fitted to the second clipping slot 303, the first main body 3141 and the third snap-fitting part 313 are located inside the second clipping slot 303.

Particularly, the second snap-fitting part 312 and the first snap-fitting part 311 of the second snap-fitting member are rotatably connected, so that the second snap-fitting part 312 is capable of driving the third clipping hook to move in the direction of approaching the second clipping slot 303 or leaving the second clipping slot 303. While the third clipping hook is entering the second clipping slot 303, the included angle between the first main body 3141 of the fourth snap-fitting part 314 and the third snap-fitting part 313 is reduced, and the first main body 3141 and the third snap-fitting part 313 enter the second clipping slot 303. After they have entered, the included angle between the first main body 3141 and the third snap-fitting part 313 recovers to the original angle, so that the second main body 3142 of the fourth snap-fitting part 314 abuts the surface of the second clipping slot 303. When it is required to disengage the third clipping hook from the second clipping slot 303, the second main body 3142 is pulled, to cause the included angle between the first main body 3141 and the third snap-fitting part 313 to be reduced, whereby the first main body 3141 and the third snap-fitting part 313 are disengaged from the second clipping slot 303.

It should be noted that, in an embodiment of the present application, the particular structure of the first snap-fitting member 213 may also be the same as the particular structure of the second snap-fitting member.

In an embodiment of the present application, the end face of the tray 100 is provided with a third wiring hole, the third wiring hole and the second cable clamps 400 are located on the same one side of the second wiring hole 102, and the third wiring hole is for the penetration by the cable that has passed through the second wiring hole 102.

Particularly, in the present embodiment, the third wiring hole is provided at the end face of the tray 100, the cable connected to the PCIE form card passes through the second wiring hole 102, subsequently passes through the second cable clamps 400 and the third wiring hole, and is connected to the power board 602 of the computation layer 600.

As shown in FIG. 1, in an embodiment of the present application, the threading device further comprises a sealing member 500, and the sealing member 500 is for, after the cable has passed through the third wiring hole, sealing the third wiring hole.

Particularly, by providing the sealing member 500 at the third wiring hole, the gap between the third wiring hole and the cable may be sealed, thereby preventing the hot air inside the server crate from flowing back. Optionally, in an embodiment of the present application, the sealing member 500 may be a foam.

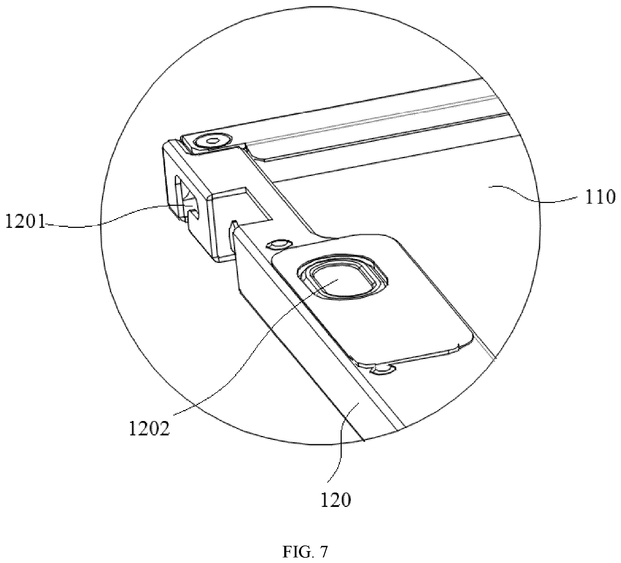

As shown in FIG. 7, in an embodiment of the present application, the tray 100 comprises a third bottom plate 110 and a border frame 120. The third bottom plate 110 is provided with the wiring hole and the cable temporarily-storing member 200, the border frame 120 encloses the periphery of the third bottom plate 110, a plurality of connecting slots 1201 are provided at the side face of the border frame 120 in the circumferential direction, and the connecting slots 1201 are for the snap fitting to the server crate.

Particularly, the plurality of connecting slots 1201 are provided at the periphery of the border frame 120. When the threading device is being installed into the server crate, the inner wall of the server crate is provided with a plurality of plugs, and each of the plugs is inserted into one of the connecting slots 1201, whereby the threading device is snap-fitted to the server crate, thereby realizing tool-free installation of the threading device.

Optionally, in an embodiment of the present application, each of the connecting slots 1201 comprises a first slot and a second slot that are connected, the first slot and the second slot are perpendicular, the first slot is provided in the height direction of the border frame 120, and the first slot extends throughout the bottom face of the border frame 120.

Particularly, in the installation, firstly the first slot is slid along the plug, subsequently the second slot is slid along the plug, whereby the plug is located inside the second slot, and the border frame 120 is lifted, thereby realizing tool-free installation of the threading device.

As shown in FIG. 7, in an embodiment of the present application, a plurality of elastic pieces 1202 are provided at the top face of the border frame 120 in the circumferential direction, and the elastic pieces 1202 are for abutting the computation layer 600.

Particularly, after the threading device has been installed into the server crate, the elastic pieces 1202 abut the computation layer 600, to serve to support the computation layer 600.

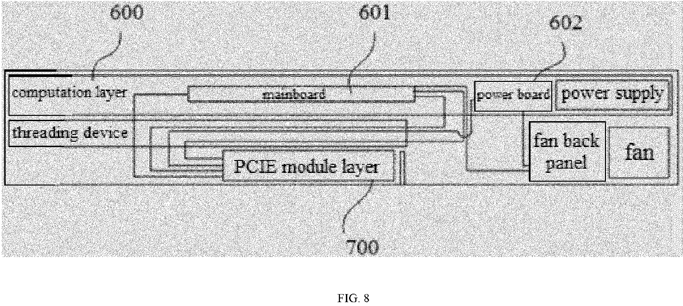

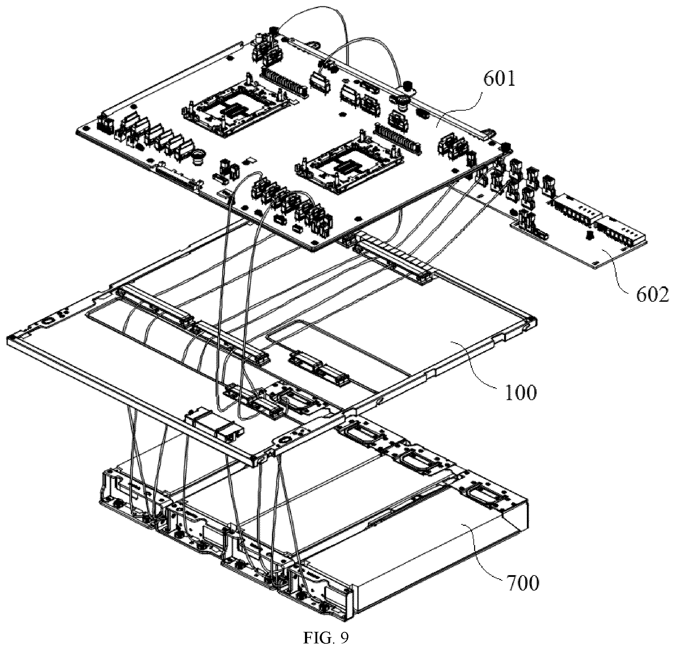

As shown in FIGS. 8 and 9, an embodiment of the present application further provides a server, wherein the server comprises a server crate, a PCIE module layer 700, the threading device and a computation layer 600. All of the PCIE module layer 700, the threading device and the computation layer 700 are provided inside the server crate, and the threading device is located between the PCIE module layer 700 and the computation layer 600. A first end of the cable is connected to the PCIE module layer 700, and a second end of the cable passes through the threading device and is connected to the computation layer 600.

Particularly, the computation layer 600 is provided with the components such as a mainboard 601 and a power board 602. The PCIE module layer 700 is provided with a PCIE form card and a Riser card. In the assembling of the server, it is required to connect the PCIE form card and the power board 602 by using a cable, and connect the Riser card and the mainboard 601 by using a cable.

In the present embodiment, firstly the PCIE module layer 700 is installed into the server crate, the cables that are connected to the PCIE form card and the Riser card are caused to pass through the wiring hole, and subsequently the threading device is installed into the server crate. The cables that have passed through the wiring hole pass through the cable temporarily-storing member 200, whereby the cable temporarily-storing member 200 may clamp the cables, subsequently the computation layer is installed into the server crate, and finally the cables are connected to the power board 602 and the mainboard 601 of the computation layer 600.

The cable temporarily-storing member 200 comprises a base and a clamping mechanism. The base is provided at the tray 100, the clamping mechanism is connected to the base, the clamping mechanism is openable and closable, and the clamping mechanism is for fixing the cable that has passed through the wiring hole. Particularly, the cable connected to the PCIE module layer 700, after passing through the wiring hole, penetrates the clamping mechanism, wherein the clamping mechanism is for fixing the cable, and, subsequently, after the computation layer 600 has been installed into the server crate, the cable is connected to the computation layer 600.

As shown in FIGS. 2 and 4, in an embodiment of the present application, the connecting plate 211 is rotatably connected to the base, and the connecting plate 211 has a first position and a second position that are switchable. When the connecting plate 211 is in the first position, the connecting plate 211 and the tray 100 are perpendicular, and the cable is located inside the cable accommodating space. When the connecting plate 211 is in the second position, the connecting plate 211 and the tray 100 are parallel, and the cable is located outside the cable accommodating space.

Particularly, after the cable has passed through the wiring hole, it is required to fix the cable. The connecting plate 211 is in the first position; in other words, the connecting plate 211 is in a vertical position, and is perpendicular to the tray 100, whereby the cable that has passed through the cable accommodating space points upwardly. After the cable has been straightened, the cable is in the vertical state by using the tension of itself and the clamping force of the clamping mechanism. After the computation layer has been installed, the first snap-fitting member 213 and the first clipping slot 2121 are disengaged, to release the cable, and the cable is connected to the computation layer. Subsequently, the connecting plate 211 is flipped, to cause it to be parallel to the tray 100; in other words, the connecting plate 211 is in a horizontal position, which is the second position of the connecting plate 211.

Optionally, in an embodiment of the present application, the connecting plate 211 may be rotatably connected to the base by a rotation shaft. In another embodiment of the present application, the connecting plate 211 may also be flexibly connected to the base. Particularly, the material of the connection between the connecting plate 211 and the base may be a flexible material such as silica gel, so that the connecting plate 211 is capable of rotating relative to the base.

As shown in FIG. 2, in an embodiment of the present application, the base comprises a first bottom plate 201 and a side plate 202. The first bottom plate 201 is provided on the tray 100, the side plate 202 is perpendicular to the first bottom plate 201, and the side plate 202 is provided with a first positioning member 203. The connecting plate 211 further has a second surface opposite to the first surface, the second surface is provided with a second positioning member 214, and when the connecting plate 211 is in the first position, the second positioning member 214 abuts the first positioning member 203.

Particularly, the first positioning member 203 and the second positioning member 214 are for positioning the rotation angle of the connecting plate 211. When the connecting plate 211 has rotated to the first position from the second position, or, in other words, when the connecting plate 211 has flipped to the vertical state from the horizontal state, the second positioning member 214 exactly abuts the first positioning member 203, which may prevent the connecting plate 211 from excessively flipping, to ensure that the connecting plate 211 is perpendicular to the first bottom plate 201.

As shown in FIG. 4, in an embodiment of the present application, second clipping hooks 204 are provided at the two ends of the first bottom plate 201, and when the connecting plate 211 is in the second position, the second clipping hooks 204 are snap-fitted to the second surface of the connecting plate 211.

Particularly, slots are provided at the two ends of the second surface of the connecting plate 211, and when the connecting plate 211 is in the second position, the second clipping hooks 204 are snap-fitted to the slots, so as to cause the clamping mechanism and the base to be fixed to form an entirety.

As shown in FIG. 1, in an embodiment of the present application, the threading device further comprises a plurality of cable clamps, the cable clamps are provided at the tray 100, and the cable clamps are for fixing the cable.

Particularly, in an embodiment of the present application, the plurality of cable clamps include a plurality of first cable clamps 300 and a plurality of second cable clamps 400. The wiring hole is a plurality of wiring holes, and the plurality of wiring holes include a first wiring hole 101 and a second wiring hole 102.

Particularly, the plurality of first cable clamps 300 are arranged between the first wiring hole 101 and the cable temporarily-storing member 200, and the first cable clamps 300 and the cable temporarily-storing member 200 are for fixing the cable that has passed through the first wiring hole 101.

Particularly, the cable connected to the Riser card sequentially passes through the first wiring hole 101 and the plurality of first cable clamps 300, and subsequently penetrates the clamping mechanism of the cable temporarily-storing member 200, and the clamping mechanism fixes the cable. After the operator has straightened the cable, the cable is in the vertical state by using the tension of itself and the clamping force of the clamping mechanism. After the computation layer 600 has been installed, the first snap-fitting member 213 and the first clipping slot 2121 of the clamping mechanism are disengaged, to release the cable, the cable is connected to the computation layer 600, and subsequently the connecting plate 211 is flipped by 90°, to cause the connecting plate 211 to be parallel to the tray 100.

Optionally, in the present embodiment, between the first wiring hole 101 and the cable temporarily-storing member 200, in the direction of extension of the cable, a plurality of first cable clamps 300 may be provided to fix the direction of extension of the cable.

The second wiring hole 102 is located between the first wiring hole 101 and the cable temporarily-storing member 200, the plurality of second cable clamps 400 are located on one side of the second wiring hole 102, and the second cable clamps 400 are for fixing the cable that has passed through the second wiring hole 102.

Particularly, the cable connected to the PCIE form card passes through the second wiring hole 102, subsequently passes through the second cable clamps 400, and is connected to the power board 602 of the computation layer 600. In an embodiment, in the direction of wiring of the cable there may be a plurality of second cable clamps 400, to fix the direction of extension of the cable.

Further, in the above embodiments, both of the first wiring hole 101 and the second wiring hole 102 are rectangular holes, and have large sizes, so that a plurality of cables may pass through the first wiring hole 101 and the second wiring hole 102 at the same time. Moreover, the large sizes may facilitate the plurality of cables to be arranged side by side, which improves the aesthetic degree of the cables wiring. In the embodiment shown in FIG. 1, the length of the second wiring hole 102 is greater than the length of the first wiring hole 101. In an embodiment, the length of the second wiring hole 102 may also be equal to the length of the first wiring hole 101, or less than the length of the first wiring hole 101, as long as it is satisfied that the first wiring hole 101 and the second wiring hole are arranged in stagger, to facilitate the cable connected to the PCIE form card to be connected to the mainboard 601.

As shown in FIGS. 5 and 6, in an embodiment of the present application, the structures of the first cable clamp 300 and the second cable clamp 400 are the same. The particular structures of the first cable clamp 300 and the second cable clamp 400 will be described in detail below by taking the first cable clamp 300 as an example.

The first cable clamp 300 comprises a second bottom plate 301, a second boss 302 and a second snap-fitting member. The second bottom plate 301 is provided on the tray 100, the second boss 302 is provided at a first end of the second bottom plate 301, and the surface of the second boss 302 that is opposite to the second bottom plate 301 is provided with a second clipping slot 303. The second snap-fitting member comprises a first snap-fitting part 311, a second snap-fitting part 312 and a third clipping hook that are sequentially connected, the first snap-fitting part 311 is perpendicular to the second bottom plate 301, and is connected to a second end of the second bottom plate 301, the second snap-fitting part 312 is rotatably connected to the first snap-fitting part 311, and the third clipping hook is capable of being snap-fitted to the second clipping slot 303.

In an embodiment, the third clipping hook comprises a third snap-fitting part 313 and a fourth snap-fitting part 314. The third snap-fitting part 313 and the second snap-fitting part 312 are perpendicular and connected, the fourth snap-fitting part 314 comprises a first main body 3141 and a second main body 3142 that are connected, the included angle between the first main body 3141 and the second main body 3142 is an obtuse angle, the first main body 3141 is elastically connected to the third snap-fitting part 313, and the included angle between the first main body 3141 and the third snap-fitting part 313 is an acute angle. When the third clipping hook is snap-fitted to the second clipping slot 303, the first main body 3141 and the third snap-fitting part 313 are located inside the second clipping slot 303.

Particularly, the second snap-fitting part 312 and the first snap-fitting part 311 of the second snap-fitting member are rotatably connected, so that the second snap-fitting part 312 is capable of driving the third clipping hook to move in the direction of approaching the second clipping slot 303 or leaving the second clipping slot 303. While the third clipping hook is entering the second clipping slot 303, the included angle between the first main body 3141 of the fourth snap-fitting part 314 and the third snap-fitting part 313 is reduced, and the first main body 3141 and the third snap-fitting part 313 enter the second clipping slot 303. After they have entered, the included angle between the first main body 3141 and the third snap-fitting part 313 recovers to the original angle, so that the second main body 3142 of the fourth snap-fitting part 314 abuts the surface of the second clipping slot 303. When it is required to disengage the third clipping hook from the second clipping slot 303, the second main body 3142 is pulled, to cause the included angle between the first main body 3141 and the third snap-fitting part 313 to be reduced, whereby the first main body 3141 and the third snap-fitting part 313 are disengaged from the second clipping slot 303.

It should be noted that, in an embodiment of the present application, the particular structure of the first snap-fitting member 213 may also be the same as the particular structure of the second snap-fitting member.

In an embodiment of the present application, the end face of the tray 100 is provided with a third wiring hole, the third wiring hole and the second cable clamps 400 are located on the same one side of the second wiring hole 102, and the third wiring hole is for the penetration by the cable that has passed through the second wiring hole 102.

Particularly, in the present embodiment, the third wiring hole is provided at the end face of the tray 100, the cable connected to the PCIE form card passes through the second wiring hole 102, subsequently passes through the second cable clamps 400 and the third wiring hole, and is connected to the power board 602 of the computation layer 600.

As shown in FIG. 1, in an embodiment of the present application, the threading device further comprises a sealing member 500, and the sealing member 500 is for, after the cable has passed through the third wiring hole, sealing the third wiring hole.

Particularly, by providing the sealing member 500 at the third wiring hole, the gap between the third wiring hole and the cable may be sealed, thereby preventing the hot air inside the server crate from flowing back. Optionally, in an embodiment of the present application, the sealing member 500 may be a foam.

As shown in FIG. 7, in an embodiment of the present application, the tray 100 comprises a third bottom plate 110 and a border frame 120. The third bottom plate 110 is provided with the wiring hole and the cable temporarily-storing member 200, the border frame 120 encloses the periphery of the third bottom plate 110, a plurality of connecting slots 1201 are provided at the side face of the border frame 120 in the circumferential direction, and the connecting slots 1201 are for the snap fitting to the server crate.

Particularly, the plurality of connecting slots 1201 are provided at the periphery of the border frame 120. When the threading device is being installed into the server crate, the inner wall of the server crate is provided with a plurality of plugs, and each of the plugs is inserted into one of the connecting slots 1201, whereby the threading device is snap-fitted to the server crate, thereby realizing tool-free installation of the threading device.

Optionally, in an embodiment of the present application, each of the connecting slots 1201 comprises a first slot and a second slot that are connected, the first slot and the second slot are perpendicular, the first slot is provided in the height direction of the border frame 120, and the first slot extends throughout the bottom face of the border frame 120.

Particularly, in the installation, firstly the first slot is slid along the plug, subsequently the second slot is slid along the plug, whereby the plug is located inside the second slot, and the border frame 120 is lifted, thereby realizing tool-free installation of the threading device.

As shown in FIG. 7, in an embodiment of the present application, a plurality of elastic pieces 1202 are provided at the top face of the border frame 120 in the circumferential direction, and the elastic pieces 1202 are for abutting the computation layer 600.

Particularly, after the threading device has been installed into the server crate, the elastic pieces 1202 abut the computation layer 600, to serve to support the computation layer 600.

In the server according to the embodiments of the present application, by providing the threading device, the cable of the PCIE module layer may be caused to pass through the wiring hole, and subsequently be fixed by the cable temporarily-storing member, to enable the cable to be in the vertical state by using the tension of the cable and the clamping force of the cable temporarily-storing member. After the computation layer has been installed, the cable is released, and subsequently the cable is connected to the computation layer. The connecting process does not require simultaneous operation by multiple persons, thereby simplifying the process of the assembling of the server, increasing the efficiency of the assembling of the server, and reducing the labor cost and the time cost.

Finally, it should be noted that the above embodiments are merely intended to explain the technical solutions of the present application, and not to limit them. Although the present application is explained in detail with reference to the above embodiments, a person skilled in the art should understand that he can still modify the technical solutions set forth by the above embodiments, or make equivalent substitutions to part of the technical features of them. However, those modifications or substitutions do not make the essence of the corresponding technical solutions depart from the scope of the technical solutions of the embodiments of the present application.

## Claims

1. A threading device, wherein the threading device comprises:
a tray (100), wherein the tray (100) is for being installed inside a server crate, and located over a peripheral component interconnect express, PCIE, module layer (700);
wherein: the tray (100) is provided with a wiring hole, and the wiring hole is for penetration by a cable; and
a cable temporarily-storing member (200) provided at the tray (100), wherein the cable temporarily-storing member (200) is for fixing the cable that has passed through the wiring hole;
wherein the cable temporarily-storing member (200) comprises:
a base comprising a first bottom plate (201) provided on the tray (100); and
a clamping mechanism connected to the base, wherein the clamping mechanism is openable and closable, and the clamping mechanism is for fixing the cable that has passed through the wiring hole;
wherein the clamping mechanism comprises:
a connecting plate (211), wherein the connecting plate (211) is connected to the base, the connecting plate (211) has a first surface, a first end of the first surface is provided with a first boss (212), and the first boss (212) is provided with a first clipping slot (2121); and
a first snap-fitting member (213), wherein a first end of the first snap-fitting member (213) is rotatably connected to a second end of the first surface, a second end of the first snap-fitting member (213) is provided with a first clipping hook (2131), the first clipping hook (2131) is capable of being snap-fitted to the first clipping slot (2121), and when the first clipping hook (2131) is snap-fitted to the first clipping slot (2121), the first snap-fitting member (213) and the connecting plate (211) form a cable accommodating space therebetween;
wherein the connecting plate (211) is rotatably connected to the base, and the connecting plate (211) has a first position and a second position that are switchable;
wherein in the first position, the connecting plate (211) and the tray (100) are perpendicular; and
in the second position, the connecting plate (211) and the tray (100) are parallel.

2. The threading device according to claim 1, wherein the base comprises a side plate (202), the side plate (202) is perpendicular to the first bottom plate (201), and the side plate (202) is provided with a first positioning member (203); and
the connecting plate (211) further has a second surface opposite to the first surface, the second surface is provided with a second positioning member (214), and in response to the connecting plate (211) being in the first position, the second positioning member (214) abuts the first positioning member (203); or
the connecting plate (211) is rotatably connected to the base by a rotation shaft; or
the connecting plate (211) is flexibly connected to the base.

3. The threading device according to claim 2, wherein second clipping hooks (204) are provided at two ends of the first bottom plate (201), and in response to the connecting plate (211) being in the second position, the second clipping hooks (204) are snap-fitted to the second surface of the connecting plate (211);
wherein slots are provided at two ends of the second surface of the connecting plate (211), and in response to the connecting plate (211) being in the second position, the second clipping hooks (204) are snap-fitted to the slots.

4. The threading device according to claim 1, wherein the threading device further comprises a plurality of cable clamps, the cable clamps are provided at the tray (100), and the cable clamps are for fixing the cable.

5. The threading device according to claim 4, wherein each of the cable clamps comprises:
a second bottom plate (301) provided on the tray (100);
a second boss (302) provided at a first end of the second bottom plate (301), wherein a surface of the second boss (302) that is opposite to the second bottom plate (301) is provided with a second clipping slot (303); and
a second snap-fitting member, wherein the second snap-fitting member comprises a first snap-fitting part (311), a second snap-fitting part (312) and a third clipping hook that are sequentially connected, the first snap-fitting part (311) is perpendicular to the second bottom plate (301), and is connected to a second end of the second bottom plate (301), the second snap-fitting part (312) is rotatably connected to the first snap-fitting part (311), and the third clipping hook is capable of being snap-fitted to the second clipping slot (303).

6. The threading device according to claim 5, wherein the third clipping hook comprises:
a third snap-fitting part (313), wherein the third snap-fitting part (313) and the second snap-fitting part (312) are perpendicular and connected; and
a fourth snap-fitting part (314), wherein the fourth snap-fitting part (314) comprises a first main body (3141) and a second main body (3142) that are connected, an included angle between the first main body (3141) and the second main body (3142) is an obtuse angle, the first main body (3141) is elastically connected to the third snap-fitting part (313), and an included angle between the first main body (3141) and the third snap-fitting part (313) is an acute angle; and
when the third clipping hook is snap-fitted to the second clipping slot (303), the first main body (3141) and the third snap-fitting part (313) are located inside the second clipping slot (303).

7. The threading device according to claim 4, wherein the wiring hole is a plurality of wiring holes, and the plurality of wiring holes include a first wiring hole (101); and
the plurality of cable clamps include a plurality of first cable clamps (300), the plurality of first cable clamps (300) are arranged between the first wiring hole (101) and the cable temporarily-storing member (200), and the first cable clamps (300) and the cable temporarily-storing member (200) are for fixing the cable that has passed through the first wiring hole (101).

8. The threading device according to claim 7, wherein the plurality of wiring holes further include a second wiring hole (102), and the second wiring hole (102) is located between the first wiring hole (101) and the cable temporarily-storing member (200); and
the plurality of cable clamps further include a plurality of second cable clamps (400), the plurality of second cable clamps (400) are located on one side of the second wiring hole (102), and the second cable clamps (400) are for fixing the cable that has passed through the second wiring hole (102).

9. The threading device according to claim 8, wherein an end face of the tray (100) is provided with a third wiring hole, the third wiring hole and the second cable clamps (400) are located on the same one side of the second wiring hole (102), and the third wiring hole is for penetration by the cable that has passed through the second wiring hole (102); or
the first wiring hole (101) and the second wiring hole (102) are arranged in stagger;
wherein the threading device further comprises a sealing member, and the sealing member is for, after the cable has passed through the third wiring hole, sealing the third wiring hole.

10. The threading device according to claim **1,** wherein the tray (100) comprises:
a third bottom plate (110), wherein the third bottom plate (110) is provided with the wiring hole and the cable temporarily-storing member (200); and
a border frame (120) enclosing a periphery of the third bottom plate (110), wherein a plurality of connecting slots (1201) are provided at a side face of the border frame (120) in a circumferential direction, and the connecting slots (1201) are for snap fitting to the server crate.

11. The threading device according to claim 10, wherein each of the connecting slots (1201) comprises a first slot and a second slot that are connected, the first slot and the second slot are perpendicular, the first slot is provided in a height direction of the border frame (120), and the first slot extends throughout a bottom face of the border frame (120); or
a plurality of elastic pieces (1202) are provided at a top face of the border frame (120) in a circumferential direction, and the elastic pieces (1202) are for abutting a computation layer (600).

12. A server, wherein the server comprises:
a server crate;
a PCIE module layer (700) provided inside the server crate;
the threading device according to any one of claims 1-11, provided inside the server crate, and located over the PCIE module layer (700); and
a computation layer (600), provided inside the server crate, and located over the threading device; and
a first end of the cable is connected to the PCIE module layer (700), and a second end of the cable extends throughout the threading device and is connected to the computation layer (600).

## Patentansprüche

1. Einfädelvorrichtung, wobei die Einfädelvorrichtung umfasst:
eine Trägerplatte (100), wobei die Trägerplatte (100) dazu bestimmt ist, in einer Serverkiste installiert zu werden, und über einer Peripheral Component Interconnect Express, PCIE, Modulschicht (700) angeordnet ist;
wobei:
die Trägerplatte (100) mit einem Verdrahtungsloch versehen ist, und das Verdrahtungsloch dazu bestimmt ist, von einem Kabel durchdrungen zu werden; und
ein Kabel-Zwischenspeicherelement (200), das an der Trägerplatte (100) vorgesehen ist, wobei das Kabel-Zwischenspeicherelement (200) dazu bestimmt ist, das Kabel zu fixieren, das durch das Verdrahtungsloch hindurchgetreten ist;
wobei das Kabel-Zwischenspeicherelement (200) umfasst:
eine Basis, die eine erste Bodenplatte (201) umfasst, die auf der Trägerplatte (100) vorgesehen ist; und
einen Klemmmechanismus, der mit der Basis verbunden ist, wobei der Klemmmechanismus öffenbar und schließbar ist, und der Klemmmechanismus dazu bestimmt ist, das Kabel zu fixieren, das durch das Verdrahtungsloch hindurchgetreten ist;
wobei der Klemmmechanismus umfasst:
eine Verbindungsplatte (211), wobei die Verbindungsplatte (211) mit der Basis verbunden ist, die Verbindungsplatte (211) eine erste Oberfläche aufweist, ein erstes Ende der ersten Oberfläche mit einem ersten Vorsprung (212) versehen ist, und der erste Vorsprung (212) mit einem ersten Klemmschlitz (2121) versehen ist; und
ein erstes Schnappverbindungselement (213), wobei ein erstes Ende des ersten Schnappverbindungselements (213) drehbar mit einem zweiten Ende der ersten Oberfläche verbunden ist, ein zweites Ende des ersten Schnappverbindungselements (213) mit einem ersten Klemmhaken (2131) versehen ist, der erste Klemmhaken (2131) in der Lage ist, in den ersten Klemmschlitz (2121) eingeschnappt zu werden, und wenn der erste Klemmhaken (2131) in den ersten Klemmschlitz (2121) eingeschnappt ist, das erste Schnappverbindungselement (213) und die Verbindungsplatte (211) einen Kabelaufnahmeraum dazwischen bilden;
wobei die Verbindungsplatte (211) drehbar mit der Basis verbunden ist, und die Verbindungsplatte (211) eine erste Position und eine zweite Position aufweist, die umschaltbar sind;
wobei in der ersten Position die Verbindungsplatte (211) und die Trägerplatte (100) senkrecht sind; und
in der zweiten Position die Verbindungsplatte (211) und die Trägerplatte (100) parallel sind.

2. Einfädelvorrichtung nach Anspruch 1, wobei die Basis eine Seitenplatte (202) umfasst, die Seitenplatte (202) senkrecht zu der ersten Bodenplatte (201) ist, und die Seitenplatte (202) mit einem ersten Positionierungselement (203) versehen ist; und
die Verbindungsplatte (211) ferner eine zweite Oberfläche gegenüber der ersten Oberfläche aufweist, die zweite Oberfläche mit einem zweiten Positionierungselement (214) versehen ist, und als Reaktion darauf, dass die Verbindungsplatte (211) in der ersten Position ist, das zweite Positionierungselement (214) an dem ersten Positionierungselement (203) anliegt; oder
die Verbindungsplatte (211) durch eine Drehwelle drehbar mit der Basis verbunden ist; oder
die Verbindungsplatte (211) flexibel mit der Basis verbunden ist.

3. Einfädelvorrichtung nach Anspruch 2, wobei zweite Klemmhaken (204) an zwei Enden der ersten Bodenplatte (201) bereitgestellt sind, und als Reaktion darauf, dass die Verbindungsplatte (211) in der zweiten Position ist, die zweiten Klemmhaken (204) an der zweiten Oberfläche der Verbindungsplatte (211) eingeschnappt sind;
wobei Schlitze an zwei Enden der zweiten Oberfläche der Verbindungsplatte (211) bereitgestellt sind, und als Reaktion darauf, dass die Verbindungsplatte (211) in der zweiten Position ist, die zweiten Klemmhaken (204) in die Schlitze eingeschnappt sind.

4. Einfädelvorrichtung nach Anspruch 1, wobei die Einfädelvorrichtung ferner eine Vielzahl von Kabelklemmen umfasst, wobei die Kabelklemmen an der Schale (100) bereitgestellt sind und die Kabelklemmen zum Fixieren des Kabels dienen.

5. Einfädelvorrichtung nach Anspruch 4, wobei jede der Kabelklemmen umfasst:
eine zweite Bodenplatte (301), die auf der Trägerplatte (100) bereitgestellt ist;
einen zweiten Vorsprung (302), der an einem ersten Ende der zweiten Bodenplatte (301) bereitgestellt ist, wobei eine Oberfläche des zweiten Vorsprungs (302), die der zweiten Bodenplatte (301) gegenüberliegt, mit einem zweiten Klemmschlitz (303) versehen ist; und
ein zweites Schnappverbindungselement, wobei das zweite Schnappverbindungselement ein erstes Schnappverbindungsteil (311), ein zweites Schnappverbindungsteil (312) und einen dritten Klemmhaken umfasst, die nacheinander verbunden sind, wobei das erste Schnappverbindungsteil (311) senkrecht zu der zweiten Bodenplatte (301) ist und mit einem zweiten Ende der zweiten Bodenplatte (301) verbunden ist, das zweite Schnappverbindungsteil (312) drehbar mit dem ersten Schnappverbindungsteil (311) verbunden ist, und der dritte Klemmhaken in der Lage ist, in den zweiten Klemmschlitz (303) eingeschnappt zu werden.

6. Einfädelvorrichtung nach Anspruch 5, wobei der dritte Klemmhaken umfasst: ein drittes Schnappverbindungsteil (313), wobei das dritte Schnappverbindungsteil (313) und das zweite Schnappverbindungsteil (312) senkrecht und verbunden sind; und
ein viertes Schnappverbindungsteil (314), wobei das vierte Schnappverbindungsteil (314) einen ersten Hauptkörper (3141) und einen zweiten Hauptkörper (3142) umfasst, die verbunden sind, ein eingeschlossener Winkel zwischen dem ersten Hauptkörper (3141) und dem zweiten Hauptkörper (3142) ein stumpfer Winkel ist, der erste Hauptkörper (3141) elastisch mit dem dritten Schnappverbindungsteil (313) verbunden ist, und ein eingeschlossener Winkel zwischen dem ersten Hauptkörper (3141) und dem dritten Schnappverbindungsteil (313) ein spitzer Winkel ist; und
wenn der dritte Klemmhaken in den zweiten Klemmschlitz (303) eingeschnappt ist, der erste Hauptkörper (3141) und das dritte Schnappverbindungsteil (313) innerhalb des zweiten Klemmschlitzes (303) angeordnet sind.

7. Einfädelvorrichtung nach Anspruch 4, wobei das Verdrahtungsloch eine Vielzahl von Verdrahtungslöchern ist und die Vielzahl von Verdrahtungslöchern ein erstes Verdrahtungsloch (101) umfasst; und
die Vielzahl von Kabelklemmen eine Vielzahl von ersten Kabelklemmen (300) umfasst, die Vielzahl von ersten Kabelklemmen (300) zwischen dem ersten Verdrahtungsloch (101) und dem Kabel-Zwischenspeicherelement (200) angeordnet ist, und die ersten Kabelklemmen (300) und das Kabel-Zwischenspeicherelement (200) dazu bestimmt sind, das Kabel zu fixieren, das durch das erste Verdrahtungsloch (101) hindurchgetreten ist.

8. Einfädelvorrichtung nach Anspruch 7, wobei die Vielzahl von Verdrahtungslöchern ferner ein zweites Verdrahtungsloch (102) umfasst und das zweite Verdrahtungsloch (102) zwischen dem ersten Verdrahtungsloch (101) und dem Kabel-Zwischenspeicherelement (200) angeordnet ist; und
die Vielzahl von Kabelklemmen ferner eine Vielzahl von zweiten Kabelklemmen (400) umfasst, die Vielzahl von zweiten Kabelklemmen (400) auf einer Seite des zweiten Verdrahtungslochs (102) angeordnet ist, und die zweiten Kabelklemmen (400) dazu bestimmt sind, das Kabel zu fixieren, das durch das zweite Verdrahtungsloch (102) hindurchgetreten ist.

9. Einfädelvorrichtung nach Anspruch 8, wobei eine Endfläche der Trägerplatte (100) mit einem dritten Verdrahtungsloch versehen ist, das dritte Verdrahtungsloch und die zweiten Kabelklemmen (400) auf derselben Seite des zweiten Verdrahtungslochs (102) angeordnet sind, und das dritte Verdrahtungsloch dazu bestimmt ist, von dem Kabel durchdrungen zu werden, das durch das zweite Verdrahtungsloch (102) hindurchgetreten ist; oder
das erste Verdrahtungsloch (101) und das zweite Verdrahtungsloch (102) versetzt angeordnet sind; wobei die Einfädelvorrichtung ferner ein Dichtungselement umfasst, und das Dichtungselement dazu bestimmt ist, das dritte Verdrahtungsloch abzudichten, nachdem das Kabel durch das dritte Verdrahtungsloch hindurchgetreten ist.

10. Einfädelvorrichtung nach Anspruch 1, wobei die Trägerplatte (100) umfasst:
eine dritte Bodenplatte (110), wobei die dritte Bodenplatte (110) mit dem Verdrahtungsloch und dem Kabel-Zwischenspeicherelement (200) versehen ist; und
einen Randrahmen (120), der einen Umfang der dritten Bodenplatte (110) umschließt, wobei eine Vielzahl von Verbindungsschlitzen (1201) an einer Seitenfläche des Randrahmens (120) in einer Umfangsrichtung vorgesehen sind, und die Verbindungsschlitze (1201) dazu bestimmt sind, mit der Serverkiste schnappverbunden zu werden.

11. Einfädelvorrichtung nach Anspruch 10, wobei jeder der Verbindungsschlitze (1201) einen ersten Schlitz und einen zweiten Schlitz umfasst, die verbunden sind, der erste Schlitz und der zweite Schlitz senkrecht sind, der erste Schlitz in einer Höhenrichtung des Randrahmens (120) vorgesehen ist, und der erste Schlitz sich durch eine Bodenfläche des Randrahmens (120) erstreckt; oder
eine Vielzahl elastischer Stücke (1202) an einer Oberseite des Randrahmens (120) in einer Umfangsrichtung vorgesehen sind, und die elastischen Stücke (1202) dazu bestimmt sind, an einer Berechnungsschicht (600) anzuliegen.

12. Server, wobei der Server umfasst:
eine Serverkiste;
eine PCIE-Modulschicht (700), die in der Serverkiste vorgesehen ist;
die Einfädelvorrichtung nach einem der Ansprüche 1-11, die in der Serverkiste vorgesehen ist und über der PCIE-Modulschicht (700) angeordnet ist; und
eine Berechnungsschicht (600), die in der Serverkiste vorgesehen ist und über der Einfädelvorrichtung angeordnet ist; und
ein erstes Ende des Kabels mit der PCIE-Modulschicht (700) verbunden ist, und ein zweites Ende des Kabels sich durch die gesamte Einfädelvorrichtung erstreckt und mit der Berechnungsschicht (600) verbunden ist.

## Revendications

1. Dispositif de filetage, dans lequel ledit dispositif de filetage comprend :
un plateau (100), dans lequel le plateau (100) est destiné à être installé à l'intérieur d'un châssis de serveur et situé au-dessus d'une couche de module d'interconnexion express de composants périphériques, PCIE, (700) ;
dans lequel :
le plateau (100) est muni d'un orifice de câblage, et l'orifice de câblage est destiné au passage d'un câble ; et
un élément de stockage temporaire de câble (200) prévu sur le plateau (100), dans lequel l'élément de stockage temporaire de câble (200) est destiné à fixer le câble qui a traversé l'orifice de câblage ;
dans lequel l'élément de stockage temporaire de câble (200) comprend :
une base comprenant une première plaque inférieure (201) prévue sur le plateau (100) ; et
un mécanisme de serrage relié à la base, dans lequel le mécanisme de serrage peut être ouvert et fermé, et le mécanisme de serrage est destiné à fixer le câble qui a traversé l'orifice de câblage ;
dans lequel le mécanisme de serrage comprend :
une plaque de liaison (211), ladite plaque de liaison (211) étant reliée à la base, la plaque de liaison (211) présentant une première surface, une première extrémité de la première surface étant pourvue d'un premier bossage (212), et le premier bossage (212) étant pourvu d'une première fente de clipsage (2121) ; et
un premier élément d'encliquetage (213), dans lequel une première extrémité du premier élément d'encliquetage (213) est reliée de manière rotative à une deuxième extrémité de la première surface, une deuxième extrémité du premier élément d'encliquetage (213) est pourvue d'un premier crochet de clipsage (2131), le premier crochet de clipsage (2131) peut s'encliqueter dans la première fente de clipsage (2121), et lorsque le premier crochet de clipsage (2131) est encliqueté dans la première fente de clipsage (2121), le premier élément de clipsage (213) et la plaque de liaison (211) forment entre eux un espace de logement de câble ;
dans lequel la plaque de liaison (211) est reliée de manière rotative à la base, et la plaque de liaison (211) présente une première position et une deuxième position qui sont permutables ;
dans lequel, dans la première position, la plaque de liaison (211) et le plateau (100) sont perpendiculaires ; et
dans la deuxième position, la plaque de liaison (211) et le plateau (100) sont parallèles.

2. Dispositif de filetage selon la revendication 1, dans lequel la base comprend une plaque latérale (202), la plaque latérale (202) est perpendiculaire à la première plaque inférieure (201), et la plaque latérale (202) est pourvue d'un premier élément de positionnement (203) ; et
la plaque de liaison (211) comporte en outre une deuxième surface opposée à la première surface, la deuxième surface est pourvue d'un deuxième élément de positionnement (214), et en réponse à la plaque de liaison (211) se trouvant dans la première position, le deuxième élément de positionnement (214) vient en butée contre le premier élément de positionnement (203) ; ou
la plaque de liaison (211) est reliée de manière rotative à la base par un axe de rotation ; ou
la plaque de liaison (211) est reliée de manière flexible à la base.

3. Dispositif de filetage selon la revendication 2, dans lequel des deuxièmes crochets de clipsage (204) sont prévus à deux extrémités de la première plaque inférieure (201), et en réponse à la plaque de liaison (211) se trouvant dans la deuxième position, les deuxièmes crochets de clipsage (204) sont encliquetés dans la deuxième surface de la plaque de liaison (211) ;
dans lequel des fentes sont prévues à deux extrémités de la deuxième surface de la plaque de liaison (211), et en réponse à la plaque de liaison (211) se trouvant dans la deuxième position, les deuxièmes crochets de clipsage (204) sont encliquetés dans les fentes.

4. Dispositif de filetage selon la revendication 1, dans lequel le dispositif de filetage comprend en outre une pluralité de serre-câbles, les serre-câbles sont prévus sur le plateau (100), et les serre-câbles sont destinés à fixer le câble.

5. Dispositif de filetage selon la revendication 4, dans lequel chacun des serre-câbles comprend :
une deuxième plaque inférieure (301) prévue sur le plateau (100) ;
un deuxième bossage (302) prévu à une première extrémité de la deuxième plaque inférieure (301), dans lequel une surface du deuxième bossage (302) opposée à la deuxième plaque inférieure (301) est pourvue d'une deuxième fente de clipsage (303) ; et
un deuxième élément d'encliquetage, dans lequel le deuxième élément d'encliquetage comprend une première partie d'encliquetage (311), une deuxième partie d'encliquetage (312) et un troisième crochet de clipsage qui sont reliés de manière séquentielle, la première partie d'encliquetage (311) est perpendiculaire à la deuxième plaque inférieure (301), et est reliée à une deuxième extrémité de la deuxième plaque inférieure (301), la deuxième partie d'encliquetage (312) est reliée de manière rotative à la première partie d'encliquetage (311), et le troisième crochet de clipsage peut s'encliqueter dans la deuxième fente de clipsage (303).

6. Dispositif de filetage selon la revendication 5, dans lequel le troisième crochet de clipsage comprend :
une troisième partie d'encliquetage (313), dans lequel la troisième partie d'encliquetage (313) et la deuxième partie d'encliquetage (312) sont perpendiculaires et reliées ; et
une quatrième partie d'encliquetage (314), dans lequel la quatrième partie d'encliquetage (314) comprend un premier corps principal (3141) et un deuxième corps principal (3142) qui sont reliés, un angle inclus entre le premier corps principal (3141) et le deuxième corps principal (3142) est un angle obtus, le premier corps principal (3141) est relié de manière élastique à la troisième partie d'encliquetage (313), et un angle inclus entre le premier corps principal (3141) et la troisième partie d'encliquetage (313) est un angle aigu ; et
lorsque le troisième crochet de clipsage est encliqueté dans la deuxième fente de clipsage (303), le premier corps principal (3141) et la troisième partie d'encliquetage (313) se trouvent à l'intérieur de la deuxième fente de clipsage (303).

7. Dispositif de filetage selon la revendication 4, dans lequel l'orifice de câblage est une pluralité d'orifices de câblage, et la pluralité d'orifices de câblage comprennent un premier orifice de câblage (101) ; et
la pluralité de serre-câbles comprennent une pluralité de premiers serre-câbles (300), la pluralité de premières serre-câbles (300) sont disposés entre le premier orifice de câblage (101) et l'élément de stockage temporaire de câble (200), et les premiers serre-câbles (300) et l'élément de stockage temporaire de câble (200) servent à fixer le câble qui a traversé le premier orifice de câblage (101).

8. Dispositif de filetage selon la revendication 7, dans lequel la pluralité d'orifices de câblage comprennent en outre un deuxième orifice de câblage (102), et le deuxième orifice de câblage (102) est situé entre le premier orifice de câblage (101) et l'élément de stockage temporaire de câble (200) ; et
la pluralité de serre-câbles comprennent en outre une pluralité de deuxièmes serre-câbles (400), la pluralité de deuxièmes serre-câbles (400) sont situés sur un côté du deuxième orifice de câblage (102), et les deuxièmes serre-câbles (400) servent à fixer le câble qui a traversé le deuxième orifice de câblage (102).

9. Dispositif de filetage selon la revendication 8, dans lequel une face d'extrémité du plateau (100) est pourvue d'un troisième orifice de câblage, le troisième orifice de câblage et les deuxièmes serre-câbles (400) sont situés sur le même côté du deuxième orifice de câblage (102), et le troisième orifice de câblage est destiné au passage du câble ayant traversé le deuxième orifice de câblage (102) ; ou
le premier orifice de câblage (101) et le deuxième orifice de câblage (102) sont disposés en quinconce ;
dans lequel le dispositif de filetage comprend en outre un élément d'étanchéité, et l'élément d'étanchéité est destiné, une fois que le câble a traversé le troisième orifice de câblage, à sceller le troisième orifice de câblage.

10. Dispositif de filetage selon la revendication 1, dans lequel le plateau (100) comprend :
une troisième plaque inférieure (110), dans lequel la troisième plaque inférieure (110) est pourvue de l'orifice de câblage et de l'élément de stockage temporaire de câble (200) ; et
un cadre périphérique (120) entourant une périphérie de la troisième plaque inférieure (110), dans lequel une pluralité de fentes de liaison (1201) sont prévues sur une face latérale du cadre périphérique (120) dans un sens circonférentiel, et les fentes de liaison (1201) sont destinées à être encliquetées dans le châssis de serveur.

11. Dispositif de filetage selon la revendication 10, dans lequel chacune des fentes de liaison (1201) comprend une première fente et une deuxième fente qui sont reliées, la première fente et la deuxième fente sont perpendiculaires, la première fente est prévue dans un sens de la hauteur du cadre périphérique (120), et la première fente s'étend sur toute une face inférieure du cadre périphérique (120) ; ou
une pluralité d'éléments élastiques (1202) sont prévus sur une face supérieure du cadre périphérique (120) dans un sens circonférentiel, et les éléments élastiques (1202) sont destinés à venir en butée contre une couche de calcul (600).

12. Serveur, dans lequel le serveur comprend :
un châssis de serveur ;
une couche de module PCIE (700) prévue à l'intérieur du châssis de serveur ;
le dispositif de filetage selon l'une quelconque des revendications 1 à 11, prévu à l'intérieur du châssis de serveur et situé au-dessus de la couche de module PCIE (700) ; et
une couche de calcul (600), prévue à l'intérieur du châssis de serveur et située au-dessus du dispositif de filetage ; et
une première extrémité du câble est connectée à la couche de module PCIE (700), et une deuxième extrémité du câble traverse le dispositif de filetage et est connectée à la couche de calcul (600).
